# EUROPEAN PATENT SPECIFICATION

(11) **EP 2 666 344 B1**
(45) Date of publication and mention of the grant of the patent: **13.03.2019**
(21) Application number: 11856070.5
(22) Date of filing: 20.01.2011
(51) Int. Cl.: H01L 21/673, H05K 1/02, H05K 3/34

(54) **CHIP CARRIER SUPPORT SYSTEMS**
UNTERSTÜTZUNGSSYSTEME FÜR CHIPTRÄGER
SYSTÈMES SUPPORTS DE PORTE-PUCE

(43) Date of publication of application: 27.11.2013
(73) Proprietor: Hewlett Packard Enterprise Development LP, Houston, TX 77070 (US)
(72) Inventor: GOH, Chi Hock, Singapore 118502 (SG); SIM, Soon Peng Jason, Singapore 118502 (SG); TEO, Poh Boon, Singapore 118502 (SG)
(74) Representative: ZBM Patents - Zea, Barlocci & Markvardsen
(86) International application number: PCT/US2011/021911
(87) International publication number: WO 2012/099593

(56) References cited:
- WO-A1-96/07983
- JP-A- 11 045 970
- JP-A- 11 118 878
- JP-A- 2008 166 377
- KR-A- 20030 069 666
- US-A1- 2008 185 692
- US-A1- 2009 236 700

## Description

### BACKGROUND

Products including chip carriers mounted to circuit boards can suffer from failures due to forces exerted on these chip carriers and/or circuit boards to which these chip carriers are coupled. For example, shock, impact, and torsional forces that arise from vibration of circuit boards and cause electrical connections such as solder joints, pads, and/or leads between chip carriers and circuit boards to fail.

Known methods of mitigating such failures include the application of adhesives to the chip carriers and circuit boards. Although such known methods can be effective at mitigating failed electrical connections, these known methods complicate removal of a chip carrier from a circuit board and/or replacement of the chip carrier at the circuit board. As a result, products including circuit boards with chip carriers can experience failures when subject to vibrations and/or other forces and serviceability of such products can be reduced. JP 2008-166377 discloses reinforcement of electronic components. US2008/0185692 discloses a shielded electronic package. US2009/236700 discloses a semiconductor device including a wiring board.

### BRIEF DESCRIPTION OF THE DRAWINGS

FIGS. 1A and 1B are schematic block diagrams of a circuit board and a chip carrier support system, according to an example.
FIGS. 2A, 2B, and 2C are schematic block diagrams of a chip carrier support structure, according to an example.
FIGS. 2D, 2E, and 2F are schematic block diagrams of a chip carrier support structure, according to another example.
FIG. 3 is a schematic block diagram of a circuit board and a chip carrier support system, according to an embodiment according to this invention.
FIG. 4A is a schematic block diagram of a chip carrier, according to an example.
FIG. 4B is a schematic block diagram of the chip carrier of FIG. 4A coupled to a circuit board, according to an example.
FIG. 5 is a flowchart of a process to couple a chip carrier support system to a circuit board, according to an example.

### DETAILED DESCRIPTION

A chip carrier is a device that contains an integrated circuit within a housing (or a space defined by the housing) and includes leads (i.e., electrically conductive pins or pads) outside the housing that are coupled to the integrated circuit within the housing. In other words, a chip carrier is a chip package or microchip. For example, processors, field programmable gate arrays ("FPGAs"), application-specific integrated circuits ("ASICs"), and other devices are typically manufactured as chip carriers.

Chip carriers are available in a variety of form factors that each conform to a specification for that form factor that defines, for example, the number of leads, the placement of the leads, the physical dimensions and/or tolerances of the leads, and/or the dimensions and/or tolerances of chip carriers that conform to that form factor. Different form factors perform differently in various operating conditions. Accordingly, manufactures of chip carriers and the integrated circuits included therein select a chip carrier form factor based on various operating conditions to which a chip carrier will be subjected.

A chip carrier is typically coupled (or attached) to a circuit board (e.g., a printed circuit board ("PCB")) by soldering the leads of the chip carrier to contacts (e.g., pads or through-holes) of the circuit board using one or more soldering processes. Often, the solder joints between the leads of the chip carrier and the contacts of the circuit board are the only means of coupling the chip carrier to the circuit board. Thus, the leads, solder joints, and contacts support stresses applied to the chip carrier and/or circuit board relative to the circuit board and/or chip carrier, respectively. For example, the leads, solder joints, and/or contacts can experience significant stress when the circuit board and/or chip carrier are subjected to shock such as vibrations.

Some chip carrier form factors are particularly susceptible to damage at the leads, solder joints, and/or contacts due to vibrations. For example, some chip carriers that conform to a Ball Grid Array ("BGA") specification suffer from circuit board pad (or contact) cratering when subjected to vibrations. More specifically, BGA chip carriers include a group of substantially parabolic or hemispherical leads at the bottom face of the chip carrier which can be soldered to corresponding contacts (or pads) on a circuit board. When a circuit board to which a BGA chip carrier is coupled (or soldered) is subjected to vibrations, shock, impact, and/or torsional forces exerted on the leads, solder joints, and contacts can cause failures. For example, the contacts can crack and/or fracture and/or the leads can separate from the contacts. These failures (or failure modes) can be particularly acute in Restriction of Hazardous Substances Directive ("RoHS") processes because solders compliant with RoHS processes are hard (relative to other non-RoHS-compliant solders) and the reflow temperatures used in RoHS processes can result in more brittle solder joints.

The effect of these failures is to sever or make unreliable an electrical connection (or path) between the integrated circuit of the chip carrier and traces of the circuit board with which the contacts are in electrical communication. Because the electrical paths between the integrated circuit of the chip carrier and one or more traces of the circuit board are broken, the product or device in which the circuit board and chip carrier are included can fail to operate properly.

One common approach to mitigating the effects of vibration on a chip carrier coupled to a circuit board includes application of an adhesive to the chip carrier and the surface of the circuit board. In other words, in addition to the solder joints between leads of the chip carrier and contacts of the circuit board, the chip carrier is attached to the circuit board with an adhesive such as, for example, an epoxy. Although this approach can be effective in reducing the failure modes discussed above, the adhesive complicates subsequent removal of the chip carrier. For example, it can be desirable to remove the chip carrier to test functionalities of the chip carrier, to test the circuit board, to replace the chip carrier, or to move the chip carrier to another circuit board and residual adhesive can remain on the circuit board and/or chip carrier. That is, the adhesive can complicate removal of the chip carrier, coupling the chip carrier to another circuit board, and/or coupling a new chip carrier to the circuit board due to the force required to separate adhesive bond between the chip carrier and circuit board due to remnants of the adhesive on the circuit board and chip carrier after the separation.

Methods, systems, and apparatus described herein can provide additional support to a chip carrier coupled to a circuit board. More specifically, methods, systems, and apparatus described herein can support a chip carrier coupled to a circuit board using one or more support structures that are separately coupled (or attached) to a chip carrier and a circuit board. That is, chip carrier support systems discussed herein can prevent or mitigate failures of electrical connections between chip carriers and circuit boards by providing support structures at the chip carriers and/or circuit boards to distribute (or redistribute) the stresses from forces applied to the chip carriers and/or circuit boards in response to vibrations. In other words, support structures discussed herein can strengthen the joints, connections, and/or couplings between a chip carrier and a circuit board. Moreover, methods, systems, and apparatus described herein can support a chip carrier coupled to a circuit board such that the chip carrier can be simply removed from the circuit board and moved to another circuit board or replaced by another chip carrier.

As used in this specification, the singular forms "a," "an," and "the" include plural referents unless the context clearly dictates otherwise. Thus, for example, the term "support structure" is intended to mean one or more support structures or a combination of support structures.

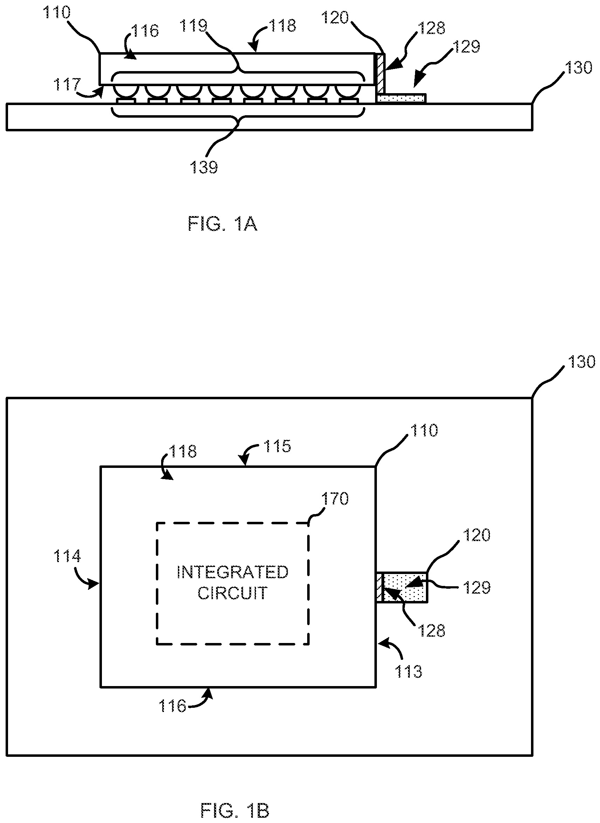

FIGS. 1A and 1B are schematic block diagrams of a circuit board and a chip carrier support system. FIG. 1A is a side perspective view of the chip carrier support system. FIG. 1B is a top perspective view of the chip carrier support system. FIGS. 1A and 1B illustrate chip carrier 110, chip carrier support structure (also referred to herein as "support structure") 120, and circuit board 130. Chip carrier 110 includes leads 119, top face 118, bottom face 117, and edge faces 116, 115, 114 and 113. Chip carrier 110 also includes integrated circuit 170 within chip carrier 110. That is, chip carrier 110 has a housing such as a plastic housing, epoxy housing, or ceramic housing within which integrated circuit is disposed. Said differently, the housing defines top face 118, bottom face 117, and edge faces 116, 115, 114 and 113 and integrated circuit 170 is encapsulated within chip carrier 110. For example, at a space or cavity defined by the housing around integrated circuit 170. In some examples, integrated circuit 170 is encased within the housing. In other words, the housing is molded against or to integrated circuit 170.

Leads 119 are in communication with integrated circuit 170. That is, signals such as electrical signals can be transferred between leads 119 and integrated circuit 170. Said differently, leads 119 are an interface between integrated circuit 170 and devices external to chip carrier 110. Circuit board 130 includes contacts (e.g., pads or through-holes) 139 to which leads 119 are coupled. For example, contacts 139 and leads 119 can be metallic and leads 119 can be soldered to contacts 139 in an RoHS process.

Support structure 120 includes vertical portion 128 and horizontal portion 129. Vertical portion 128 is coupled to chip carrier 110 and horizontal portion 129 is coupled to circuit board 130. As illustrated in FIG. 1B, vertical portion 128 is coupled to edge face 113 of chip carrier 110. Vertical portion 128 forms a complementary fit with chip carrier 110. Said differently, vertical portion 128 is configured to interface (or join or mate) with the portion of chip carrier 110 (e.g., edge face 113) adjacent to vertical portion 128.

Vertical portion 128 and chip carrier 110 can be coupled one to another using a variety of methodologies, devices, and/or coupling compounds. For example, vertical portion 128 can be coupled to chip carrier 110 at edge face 113 using solder or an adhesive such as epoxy. In some examples, vertical portion 128 can be coupled to chip carrier 110 using a compression fit, a friction fit, a snap fit, a magnetic coupling, and/or an annular lock. Thus, chip carrier 110 and/or support structure 120 can include features such as protrusions, ridges, flanges, indentations, magnets, and/or other features via which vertical portion 128 can be coupled to chip carrier 110. Such fits and/or locks can be permanent, semi-permanent (i.e., require a tool to disengage), removable, or non-removable (e.g., removable subject to actuation or disengagement of one or more features).

Similarly, horizontal portion 129 and circuit board 130 can collectively form a complementary fit and be coupled together. For example, horizontal portion 129 can be soldered to an exposed metallic portion of circuit board 130. Alternatively, for example, support structure 120 and/or circuit board 130 can include features such as protrusions, ridges, flanges, indentations, and/or other features via which horizontal portion 129 can be coupled to circuit board 130 via a compression fit, a friction fit, a snap fit, and/or an annular lock. As yet another alternative, horizontal portion 129 can be coupled to circuit board 130 using an adhesive. Thus, support structure 120 is a device or structure that is coupleable to a chip carrier and a circuit board to provide structural support to the chip carrier.

In one example, support structure 120 is coupled to chip carrier 110 and circuit board 130 with solder. Such an example can be particularly advantageous where chip carrier 110 is soldered to circuit board 130 and may be later removed from circuit board 130 because leads 119 can be separated from contacts 139 of circuit board 130, vertical portion 128 can be separated from chip carrier 110, and horizontal portion 129 can be separated from circuit board 130 using a common removal (e.g., desoldering) process. Moreover, such examples prevent support structure 120 from interfering with a flush coupling of leads 119 and contact 139 because leads 119 can be flush coupled to contacts 139 independent of coupling support structure 120 to chip carrier 110 to circuit board 130.

In some examples, support structure 120 is a portion of chip carrier 110. In other words, support structure 120 can be a feature or element of chip carrier 110. For example, the support structure 120 can be molded or fused to the housing of chip carrier 110. In such examples, support structure 120 should be sized appropriately such that horizontal portion 129 can be coupled to circuit board 130 without preventing leads 119 from being coupled to contacts 139. More specifically, if support structure 120 is too tall with respect to circuit board 130, contacts 139, and leads 119, leads 119 may be prevented from flush coupling to contacts 139. Alternatively, if support structure 120 is too short with respect to circuit board 130, contacts 139, and leads 119, horizontal portion 129 of support structure 120 may not be in contact with circuit board 130 when leads 119 are coupled flush to contacts 139.

Although support structure 120 is illustrated in FIGS. 1A and 1B as a right-angle (or 90-degree) support structure, support structure 120 can have other forms. For example, if an edge face (or other face) of chip carrier 110 forms an angle other than a right angle with circuit board 130, support structure 120 can have a form (e.g., be at an angle) that provides a complementary fit of support structure 120 with that face of chip carrier 110 and circuit board 130.

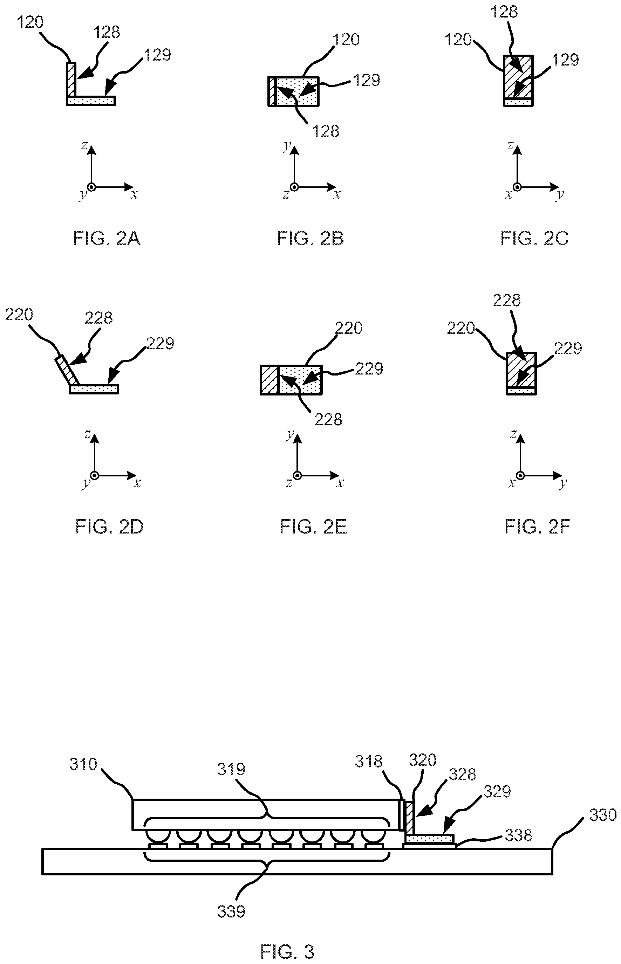

FIGS. 2A, 2B, and 2C are schematic block diagrams of a chip carrier support structure. More specifically, FIG. 2A illustrates a side perspective view of chip carrier support structure 120, FIG. 2B illustrates a top perspective view of chip carrier support structure 120, and FIG. 2C illustrates a front perspective view of chip carrier support structure 120. Chip carrier support structure 120 can be formed or manufactured using a variety of methodologies. For example, chip carrier support structure 120 can be formed (e.g., bent, molded, machined, etc.) from a single (e.g., monolithic) structure or material. Alternatively, for example, one or more structures or materials can be coupled one to another to manufacture chip carrier support structure 120. Moreover, chip carrier support structure 120 can be manufactured or formed from one any of a variety of materials. For example, chip carrier support structure 120 can be manufactured from a metal, an alloy, a plastic, a ceramic, and/or some other material or combination thereof.

Chip carrier support structure (or "support structure") 120 includes portion 128 and portion 129. Portion 128 is configured to form a complementary fit with a portion - such as an edge face or other face or portion of a chip carrier and portion 129 is configured to form a complementary fit with a portion of a circuit board. Said differently, support structure 120 is configured such that portion 128 can be coupled to a chip carrier while portion 129 and leads of the chip carrier are coupled to a circuit board. In some examples, support structure 120 can be in a configuration other than the right-angle (or 90-degree) configuration illustrated in FIGS. 2A, 2B, and 2C. That is, portion 128 can be non-vertical and/or portion 129 can be non-horizontal.

For example, FIGS. 2D, 2E, and 2F are schematic block diagrams of a chip carrier support structure, according to another example. More specifically, FIG. 2D illustrates a side perspective view of chip carrier support structure 220, FIG. 2E illustrates a top perspective view of chip carrier support structure 220, and FIG. 2F illustrates a front perspective view of chip carrier support structure 220.

As illustrated in FIGS. 2D, 2E, and 2F illustrate support structure 220 that includes portion 228 and portion 229 that do not form a right angle with respect one to another. Rather, portion 228 and portion 229 that form an obtuse angle with respect one to another. In other examples, portion 228 and portion 229 can form an acute angle with respect one to another. As another alternative, portion 228 and/or portion 229 can be curved or have shapes different from those illustrated in FIGS. 2A, 2B, 2C, 2D, 2E, and 2F.

Referring to FIGS. 2A, 2B, and 2C, in some examples, support structure 120 can include features (not shown) such as protrusions, ridges, flanges, indentations, and/or other features by which portion 128 can be coupled to a chip carrier with a compression fit, a friction fit, a snap fit, and/or an annular lock. In other words, such features and/or complementary features at the chip carrier can define a complementary fit between support structure 120 and the chip carrier. Similarly, support structure 120 can include features (not shown) such as protrusions, ridges, flanges, indentations, and/or other features by which portion 129 can be coupled to a circuit board with a compression fit, a friction fit, a snap fit, and/or an annular lock. Such features and/or complementary features at the circuit board can define a complementary fit between support structure 120 and the circuit board.

In some examples, a chip carrier and/or a circuit board can includes a support structure receiver to receive and/or form a compression fit, a friction fit, a snap fit, and/or an annular lock with a support structure. For example, FIG. 3 is a schematic block diagram of a circuit board and a chip carrier support system, according to an embodiment of this invention. FIG. 3 illustrates chip carrier 310, support structure 320, and circuit board 330. Leads 319 of chip carrier 310 are coupled to contacts 339 of circuit board 330, for example, with solder. Additionally, chip carrier 310 includes support structure receiver 318 and circuit board 330 includes support structure receiver 338.

Support structure receivers 318 and 338 are portions or elements of chip carrier 310 and circuit board 330, respectively, that receive (or mate or join with) portion 328 and portion 329, respectively, of support structure 320. Said differently, there is a complementary fit between support structure receivers 318 and 338 and portions 328 and 329, respectively. For example, support structure receivers 318 and 338 can be metallic pads to which support structure 320 can be soldered. More specifically, support structure receiver 318 can be a metallic pad partially or wholly embedded within the housing of chip carrier 310 and support structure 338 can be a metallic pad at circuit board 330. In some embodiments, support structure receiver 318 can be in communication with an integrated circuit of chip carrier 310. For example, support structure receiver 318 can be a ground or power lead of chip carrier 310 via which an operational power or a ground reference is provided to the integrated circuit. Additionally, support structure receiver 338 can be a ground or power contact of circuit board 330. Thus, support structure 320 can be manufactured from an electrically conductive material and define an electrical path between support structure receiver 318 and support structure receiver 338 when coupled (e.g., soldered) to support structure receiver 318 and support structure receiver 338.

Alternatively, for example, support structure receivers 318 and 338 can be portions of chip carrier 310 and circuit board 330, respectively, to which support structure 320 can be adhesively coupled. For example, support structure receivers 318 and 338 can be portions of chip carrier 310 and circuit board 330, respectively, that are configured to be coupled to support structure 320 with an adhesive (e.g., reinforced or made of a material that will not be degraded by an adhesive). In some embodiments, support structure receivers 318 and/or 338 can include features (not shown) such as protrusions, ridges, flanges, indentations, and/or other features to engage portions 328 and/or 329 (or features thereof), respectively, to couple support structure 320 to chip carrier 310 and/or circuit board 330 with a compression fit, a friction fit, a snap fit, and/or an annular lock.

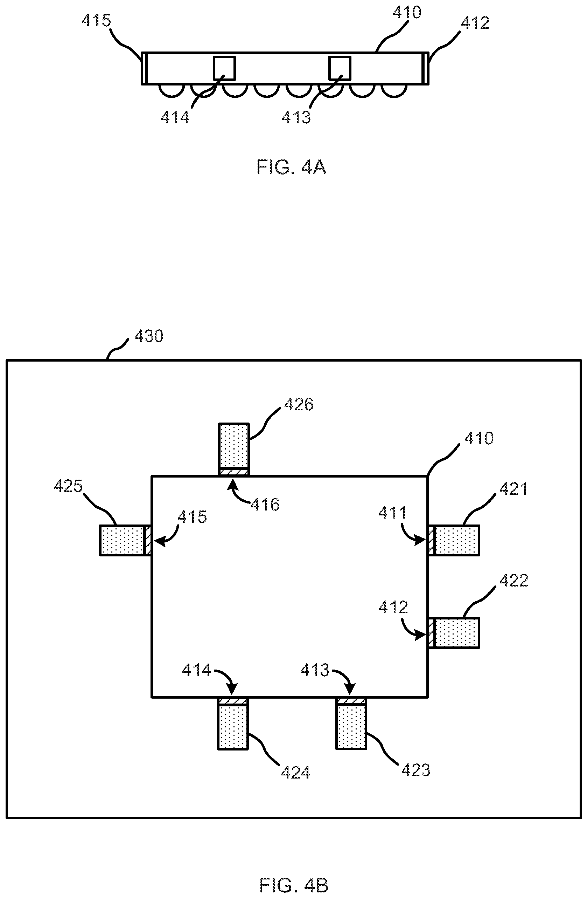

FIGS. 4A and 4B illustrate a chip carrier support system including multiple support structures and support structure receivers. FIG. 4A is a schematic block diagram of a chip carrier, according to an example. More specifically, FIG. 4A illustrates a side perspective view of chip carrier 410. Chip carrier 410 includes support structure receivers 411, 412, 413, 414, 415, and 416.

FIG. 4B is a schematic block diagram of chip carrier 410 coupled to circuit board 430, according to an example. As illustrated in FIG. 4B, chip carrier 410 is operatively coupled to circuit board 430 by support structures 421, 422, 423, 424, 425, and 426. More specifically, support structure 421 is coupled to chip carrier 410 at support structure receiver 411, support structure 422 is coupled to chip carrier 410 at support structure receiver 412, support structure 423 is coupled to chip carrier 410 at support structure receiver 413, support structure 424 is coupled to chip carrier 410 at support structure receiver 414, support structure 425 is coupled to chip carrier 410 at support structure receiver 415, and support structure 426 is coupled to chip carrier 410 at support structure receiver 416. Additionally, each of support structures 421, 422, 423, 424, 425, and 426 is coupled to circuit board 430, for example, at support structure receivers (not shown) of circuit board 430.

As illustrated in FIG. 4B, the support structures are asymmetrically distributed at chip carrier 410. That is, the support structures are coupled to the edge faces of chip carrier 410 in different numbers and/or in different positions. In some examples, the support structures can be a symmetrically distributed at chip carrier 410 or at two or more faces of chip carrier 410.

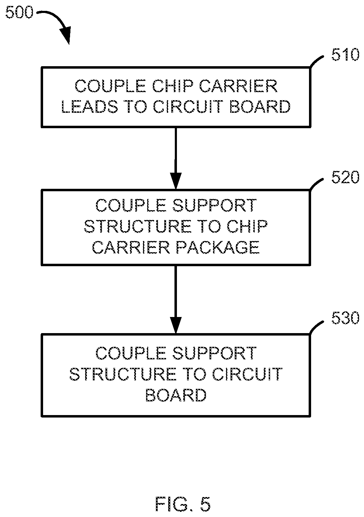

FIG. 5 is a flowchart of process 500 to couple a chip carrier support system to a circuit board, according to an embodiment of this invention. Leads of a chip carrier are coupled to a circuit board at block 510. For example, metallic leads of a chip carrier are soldered to the metallic pads of a circuit board to connect the chip carrier to a system (i.e., a device or product) including the circuit board.

One or more support structures are then coupled to the chip carrier package at block 520. The one or more support structures can be coupled to the chip carrier using solder, adhesive, a compression fit, a friction fit, a snap fit, and/or an annular lock. In some embodiments, the chip carrier and/or support structures include features such as protrusions, ridges, flanges, indentations, and/or other features to complementarily engage one another to couple each support structure to the chip carrier. Furthermore, a chip carrier can include support structure receivers and the support structures can be coupled to these support structure receivers.

The one or more support structures are then coupled to the circuit board at block 530. Similarly to block 520, the one or more support structures can be coupled to the circuit board using solder, adhesive, a compression fit, a friction fit, a snap fit, and/or an annular lock. In some embodiments, the circuit board and/or support structures include features such as protrusions, ridges, flanges, indentations, and/or other features to complementarily engage one another to couple each support structure to the circuit board. Furthermore, a circuit board can include support structure receivers and the support structures can be coupled to these support structure receivers.

In some embodiments, process 500 can include additional and/or fewer blocks than illustrated in FIG. 5. For example, a chip carrier can be manufactured or distributed with support structures attached to or included at the chip carrier. Thus, block 520 can be omitted. Furthermore, some blocks can be rearranged. As a specific example, rather than coupling a group of support structures to a chip carrier and then coupling that group of support structure to a circuit board, each support structure can in turn be coupled to the chip carrier and then to the circuit board. Moreover, support structure can be coupled to the circuit board and then coupled to the chip carrier.

## Claims

1. A chip carrier support system, comprising:
a circuit board (330);
a chip carrier support structure (320); and
a chip carrier (310) adapted to form a complementary fit with the chip carrier support structure (320) at an edge face of the chip carrier (310) and having an integrated circuit and a plurality of leads (319) in communication with the integrated circuit, the chip carrier (310) comprising a housing wherein:
the chip carrier (310) includes a support structure receiver (318) at the edge face to form the complementary fit with the chip carrier support structure (320),
the chip carrier support structure (320) includes a first portion (328) and a second portion (329); wherein
the first portion (328) of the chip carrier support structure (320) is coupled to the support structure receiver (318) of the chip carrier (310); and
the second portion (329) of the chip carrier support structure (320) is coupled to a metallic pad (338) at the circuit board (330), and the plurality of leads (319) of the chip carrier (310) are coupled to a plurality of contacts (339) of the circuit board (330), **characterized in that** the support structure receiver (318) is a metallic pad partially or wholly embedded within the housing and an electrical path is defined between the metallic pad partially or wholly embedded within the housing and the metallic pad (338) at the circuit board.

2. The chip carrier support system of claim 1, wherein:
the first portion (328) of the chip carrier support structure (320) is soldered to the support structure receiver (318) of the chip carrier (310); and
the second portion (329) of the chip carrier support structure (320) is soldered to the circuit board (330) when the plurality of leads (319) of the chip carrier (310) are coupled to a plurality of contacts (339) of the circuit board (330) and the first portion (328) of the chip carrier support structure (320) is soldered to the support structure receiver (318) of the chip carrier (310).

3. The chip carrier support system of claim 1, wherein:
the chip carrier support structure (320) includes a snap fit feature; and
the support structure receiver (318) includes a snap fit feature that is complementary to the snap fit feature of the chip carrier support structure (320).

4. The chip carrier support system of claim 1, wherein the plurality of leads (319) of the chip carrier (310) conform to a Ball Grid Array specification.

5. The chip carrier support system of claim 1, wherein:
the plurality of leads (319) of the chip carrier (310) is at a bottom face of the chip carrier (310).

6. A method to couple a chip carrier (310) and a chip carrier support structure (320) to a circuit board (330), to form a chip carrier support system according to any of claims 1 to 5, the method comprising:
coupling a plurality of leads (319) of a chip carrier (310) to a plurality of contacts (339) at a circuit board (330);
coupling a first portion (328) of a chip carrier support structure (320) to a support structure receiver (318) at the chip carrier; the support structure receiver (318) being the metallic pad partially or wholly embedded within the housing; and
coupling a second portion (329) of the chip carrier support structure (320) to a metallic pad (338) at the circuit board (330), whereby an electrical path is defined when the metallic pad partially or wholly embedded within the housing and the metallic pad (338) at the circuit board (330) are coupled.

7. The method of claim 6, wherein:
the coupling the plurality of leads (319) of the chip carrier (310) to the plurality of contacts (339) at the circuit board (330) includes soldering;
the coupling the first portion (328) of the chip carrier support structure (320) to the support structure receiver (318) at the chip carrier (310) includes soldering; and
the coupling the second portion (329) of the chip carrier support structure (320) to the metallic pad (348) at the circuit board (330) includes soldering.

8. The method of claim 6, wherein:
the plurality of leads (319) of the chip carrier (310) are at a bottom face of the chip carrier (310).

## Patentansprüche

1. Chip-Carrier-Trägersystem, umfassend:
eine Leiterplatte (330);
eine Chip-Carrier-Trägerstruktur (320); und
einen Chip-Carrier (310), der dafür ausgelegt ist, an einer Randfläche des Chip-Carriers (310) einen komplementären Sitz mit der Chip-Carrier-Trägerstruktur (320) zu bilden, und der eine integrierte Schaltung und mehrere mit der integrierten Schaltung in Verbindung stehende Leiter (319) aufweist, wobei der Chip-Carrier (310) ein Gehäuse umfasst, wobei:
der Chip-Carrier (310) eine Trägerstrukturaufnahme (318) an der Randfläche aufweist, um den komplementären Sitz mit der Chip-Carrier-Trägerstruktur (320) zu bilden.
die Chip-Carrier-Trägerstruktur (320) einen ersten Abschnitt (328) und einen zweiten Abschnitt (329) aufweist; wobei
der erste Abschnitt (328) der Chip-Carrier-Trägerstruktur (320) mit der Trägerstrukturaufnahme (318) des Chip-Carriers (310) gekoppelt ist; und
der zweite Abschnitt (329) der Chip-Carrier-Trägerstruktur (320) mit einem metallischen Pad (338) an der Leiterplatte (330) gekoppelt ist und die mehreren Leiter (319) des Chip-Carriers (310) mit mehreren Kontakten (339) der Leiterplatte (330) gekoppelt sind, **dadurch gekennzeichnet, dass** die Trägerstrukturaufnahme (318) ein metallisches Pad ist, das teilweise oder ganz im Gehäuse eingebettet ist, und
ein elektrischer Pfad zwischen dem teilweise oder ganz im Gehäuse eingebetteten metallischen Pad (338) an der Leiterplatte definiert ist.

2. Chip-Carrier-Trägersystem nach Anspruch 1, wobei:
der erste Abschnitt (328) der Chip-Carrier-Trägerstruktur (320) an die Trägerstrukturaufnahme (318) des Chip-Carriers (310) gelötet ist; und
der zweite Abschnitt (329) der Chip-Carrier-Trägerstruktur (320) an die Leiterplatte (330) gelötet ist, wenn die mehreren Leiter (319) des Chip-Carriers (310) mit mehreren Kontakten (339) der Leiterplatte (330) gekoppelt sind und der erste Abschnitt (328) der Chip-Carrier-Trägerstruktur (320) an die Trägerstrukturaufnahme (318) des Chip-Carriers (310) gelötet ist.

3. Chip-Carrier-Trägersystem nach Anspruch 1, wobei:
die Chip-Carrier-Trägerstruktur (320) ein Verrastungsmerkmal aufweist; und
die Trägerstrukturaufnahme (318) ein Verrastungsmerkmal aufweist, das komplementär ist zu dem Verrastungsmerkmal der Chip-Carrier-Trägerstruktur (320).

4. Chip-Carrier-Trägersystem nach Anspruch 1, wobei die mehreren Leiter (319) des Chip-Carriers (310) einer Ball-Grid-Array-Spezifikation gerecht werden.

5. Chip-Carrier-Trägersystem nach Anspruch 1, wobei:
die mehreren Leiter (319) des Chip-Carriers (310) an einer unteren Fläche des Chip-Carriers (310) liegen.

6. Verfahren zum Koppeln eines Chip-Carriers (310) und einer Chip-Carrier-Trägerstruktur (319) mit einer Leiterplatte (330), um ein Chip-Carrier-Trägersystem nach einem der Ansprüche 1 bis 5 zu bilden, wobei das Verfahren umfasst:
Koppeln mehrerer Leiter (319) eines Chip-Carriers (310) mit mehreren Kontakten (339) an einer Leiterplatte (330);
Koppeln eines ersten Abschnitts (328) der Chip-Carrier-Trägerstruktur (320) mit einer Trägerstrukturaufnahme (318) am Chip-Carrier; wobei die Trägerstrukturaufnahme (318) das metallische Pad ist, das teilweise oder ganz im Gehäuse eingebettet ist; und
Koppeln eines zweiten Abschnitts (329) der Chip-Carrier-Trägerstruktur (320) an ein metallisches Pad (338) an der Leiterplatte (330), wodurch ein elektrischer Pfad definiert wird, wenn das metallische Pad, das teilweise oder ganz im Gehäuse eingebettet ist, und das metallische Pad (338) an der Leiterplatte (330) gekoppelt werden.

7. Verfahren nach Anspruch 6, wobei:
das Koppeln der mehreren Leiter (319) des Chip-Carriers (310) mit den mehreren Kontakten (339) an einer Leiterplatte (330) ein Löten beinhaltet;
das Koppeln des ersten Abschnitts (328) der Chip-Carrier-Trägerstruktur (320) an die Trägerstrukturaufnahme (318) des Chip-Carriers (310) ein Löten beinhaltet; und
das Koppeln des zweiten Abschnitts (329) der Chip-Carrier-Trägerstruktur (320) an das metallische Pad (348) an der Leiterplatte (330) ein Löten beinhaltet.

8. Verfahren nach Anspruch 6, wobei:
die mehreren Leiter (319) des Chip-Carriers (310) an einer unteren Fläche des Chip-Carriers (310) liegen.

## Revendications

1. Système de support de porte-puce, comprenant :
une carte de circuit (330) ;
une structure de support de porte-puce (320) ; et
un porte-puce (310) conçu pour former un ajustement complémentaire avec la structure de support de porte-puce (320) au niveau d'une face de bord du porte-puce (310) et ayant un circuit intégré et une pluralité de fils (319) en communication avec le circuit intégré, le porte-puce (310) comprenant un boîtier dans lequel :
le porte-puce (310) inclut un récepteur de structure de support (318) au niveau de la face de bord pour former l'ajustement complémentaire avec la structure de support de porte-puce (320),
la structure de support de porte-puce (320) inclut une première partie (328) et une seconde partie (329) ; dans lequel
la première partie (328) de la structure de support de porte-puce (320) est couplée au récepteur de structure de support (318) du porte-puce (310) ; et
la seconde partie (329) de la structure de support de porte-puce (320) est couplée à une pastille métallique (338) au niveau de la carte de circuit (330), et la pluralité de fils (319) du porte-puce (310) sont couplés à une pluralité de contacts (339) de la carte de circuit (330), **caractérisé en ce que** le récepteur de structure de support (318) est une pastille métallique partiellement ou totalement intégrée au boîtier et un chemin électrique est défini entre la pastille métallique partiellement ou totalement intégré au boîtier et la pastille métallique (338) au niveau de la carte de circuit.

2. Système de support de porte-puce selon la revendication 1, dans lequel :
la première partie (328) de la structure de support de porte-puce (320) est soudée au récepteur de structure de support (318) du porte-puce (310) ; et
la seconde partie (329) de la structure de support de porte-puce (320) est soudée à la carte de circuit (330) lorsque la pluralité de fils (319) du porte-puce (310) sont couplés à une pluralité de contacts (339) de la carte de circuit (330) et la première partie (328) de la structure de support de porte-puce (320) est soudée au récepteur de structure de support (318) du porte-puce (310).

3. Système de support de porte-puce selon la revendication 1, dans lequel :
la structure de support de porte-puce (320) inclut une caractéristique encliquetable ; et
le récepteur de structure de support (318) inclut une caractéristique encliquetable qui est complémentaire à la caractéristique encliquetable de la structure de support de porte-puce (320).

4. Système de support de porte-puce selon la revendication 1, dans lequel la pluralité de fils (319) du porte-puce (310) sont conformes à une spécification de grille matricielle à billes.

5. Système de support de porte-puce selon la revendication 1, dans lequel :
la pluralité de fils (319) du porte-puce (310) se trouve sur une face inférieure du porte-puce (310).

6. Procédé de couplage d'un porte-puce (310) et d'une structure de support de porte-puce (320) à une carte de circuit (330) pour former un système de support de porte-puce selon l'une quelconque des revendications 1 à 5, le procédé comprenant :
le couplage d'une pluralité de fils (319) d'un porte-puce (310) à une pluralité de contacts (339) au niveau d'une carte de circuit (330) ;
le couplage d'une première partie (328) d'une structure de support de porte-puce (320) à un récepteur de structure de support (318) au niveau du porte-puce ; le récepteur de structure de support (318) étant la pastille métallique partiellement ou totalement intégrée au boîtier ; et
le couplage d'une seconde partie (329) de la structure de support de porte-puce (320) à une pastille métallique (338) au niveau de la carte de circuit (330), moyennant quoi un chemin électrique est défini lorsque la pastille métallique est partiellement ou totalement intégrée au boîtier et la pastille métallique (338) au niveau de la carte de circuit (330) sont couplés.

7. Procédé selon la revendication 6, dans lequel :
le couplage de la pluralité de fils (319) du porte-puce (310) à la pluralité de contacts (339) au niveau de la carte de circuit (330) inclut une soudure ;
le couplage de la première partie (328) de la structure de support de porte-puce (320) au récepteur de structure de support (318) au niveau du porte-puce (310) comprend une soudure ; et
le couplage de la seconde partie (329) de la structure de support de porte-puce (320) à la pastille métallique (348) au niveau de la carte de circuit (330) inclut une soudure.

8. Procédé selon la revendication 6, dans lequel :
la pluralité de fils (319) du porte-puce (310) se trouvent sur une face inférieure du porte-puce (310).
